# EUROPEAN PATENT APPLICATION

(11) **EP 4 773 796 A2**
(43) Date of publication of application: **08.07.2026**
(21) Application number: 25215536.1
(22) Date of filing: 13.11.2025
(51) Int. Cl.: H10W 44/00, H10W 70/09, H10W 74/10, H10W 70/60, H10D 1/00, H10W 90/20, H10W 72/00

(54) **MOLDED DEVICE PACKAGES WITH CAPACITIVE STRUCTURES**

(30) Priority: 11.12.2024 US 202418977322
(71) Applicant: NXP USA, Inc., Austin, TX 78735 (US)
(72) Inventor: Shah, Ankur Shailesh, 5656AG Eindhoven (NL); Vincent, Michael B, 5656AG Eindhoven (NL); Gong, Zhiwei, 5656AG Eindhoven (NL)
(74) Representative: Colaiuda, Antonella

(57) **Abstract**

One or more integrated capacitors can be formed within the molding material(s) of a molded electronic device package. An electronic device such as a semiconductor die is surrounded by a first volume of molding material and a first capacitor plate is formed on a top surface of the first volume of molding material above the electronic device. A second volume of molding material is formed above the first capacitor plate and a second capacitor plate is formed on a top surface of the second volume of molding material which separates the second capacitor plate from the first capacitor plate.

## Description

### TECHNICAL FIELD

Embodiments of the subject matter described herein relate to molded electronic device packages and methods of forming molded device packages that include discrete capacitors.

### BACKGROUND

Semiconductor devices and other electronic components are frequently encapsulated or otherwise assembled within molded polymer packages which can protect the devices from damage and provide macroscopic electrical contacts that allow the devices to be integrated into standardized sockets or soldered onto circuit boards. Some device packages include multiple device die that are interconnected within the package and some device packages include discrete passive devices such as capacitors and inductors.

### SUMMARY

In an example embodiment, a device package includes a first electronic device surrounded by a first volume of molding material; a second volume of molding material formed over the first volume of molding material; and a capacitor electrically coupled to the first electronic device. The capacitor includes a first capacitor plate formed on a top surface of the first volume of molding material above the first electronic device; and a second capacitor plate formed on a top surface on the second volume of molding material that is separated from the first capacitor plate by the second volume of molding material.

In another example embodiment a method of forming a device package includes surrounding a first electronic device with a first volume of molding material and forming a capacitor that is electrically coupled to the first electronic device. The capacitor is formed by forming a first capacitor plate formed on a surface of the first volume of molding material; forming a second volume of molding material formed over the first volume of molding material; and forming a second capacitor plate on a surface on the second volume of molding material that is separated from the first capacitor plate by the second volume of molding material.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
**FIG.** 1A is a schematic cross-sectional view of a capacitor integrated into molding material of a device package according to one or more embodiments disclosed herein;
**FIG.** 1B is a schematic cross-sectional view of a capacitor integrated into molding material of another device package according to one or more embodiments disclosed herein;
FIG. 2 is a schematic cross-sectional view of a capacitor with interdigitated plates integrated into molding material of another device package according to one or more embodiments disclosed herein; and
FIG. 3 is a flow-chart with cross-sectional illustrations of a process suitable for use in fabricating a device package with an integrated capacitor according to one or more embodiments disclosed herein.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, elements in the Drawings are not necessarily drawn to scale. For example, the dimensions of some of the elements or regions in the figures may be exaggerated relative to other elements or regions to help improve understanding of embodiments of the invention. Directional references such as "top," "bottom," "left," "right," "above," "below," and so forth, unless otherwise stated, are not intended to require any preferred orientation, and are made with reference to the orientation of the corresponding figure or figures for purposes of illustration. In addition, the Figures and Detailed Description may omit well-known and conventional features for clarity.

It is often desirable to integrate passive devices such as capacitors and inductors with active semiconductor devices or other electronic devices in a single device package. Conventional approaches include passive devices formed within one or more semiconductor die or attaching or otherwise connecting discrete passive components within or on the device package. However, these approaches can have drawbacks. For example, because semiconductor substrates and fabrication processes can be costly compared to those used for discrete passive components, integrating passive devices into semiconductor die can result in increased manufacturing costs and lower packaging density due to the real estate required to fabricate passive devices on a semiconductor die. Meanwhile, placing and connecting discrete passive devices can also result in increased package size and costs due to the comparatively large size of discrete components, and the limited positioning accuracy of automated pick-and-place equipment or manual assembly processes.

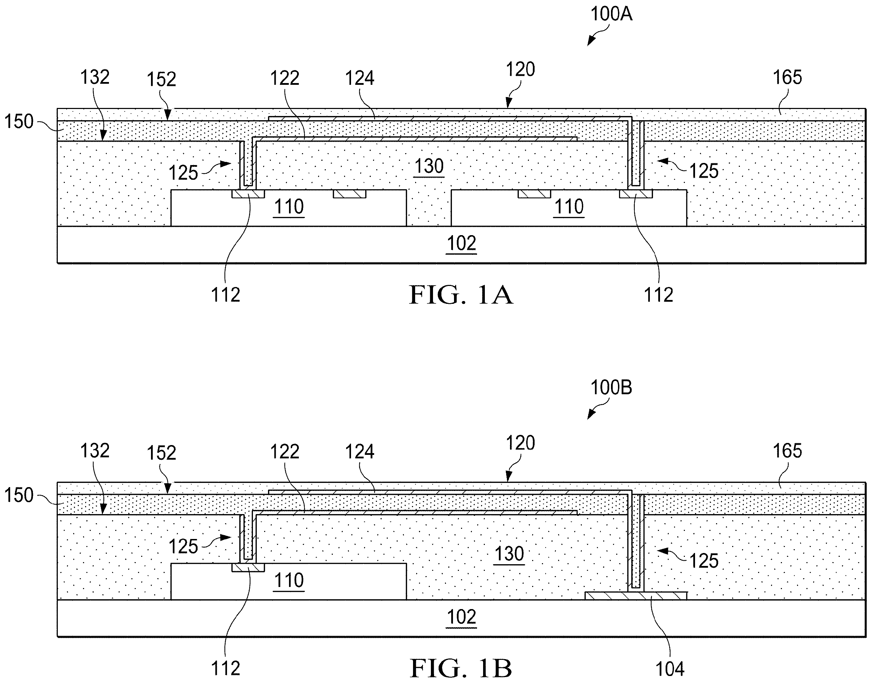

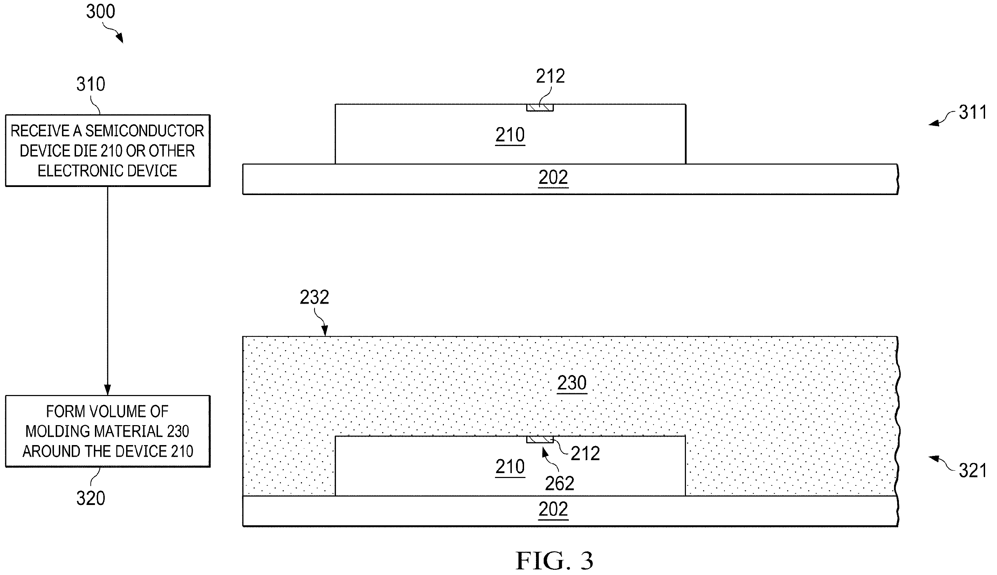

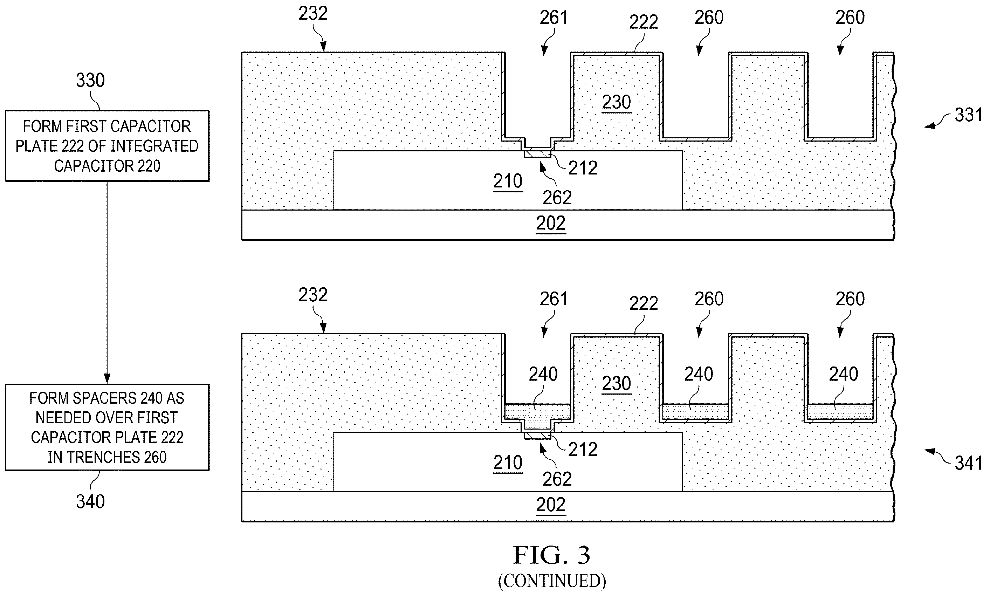

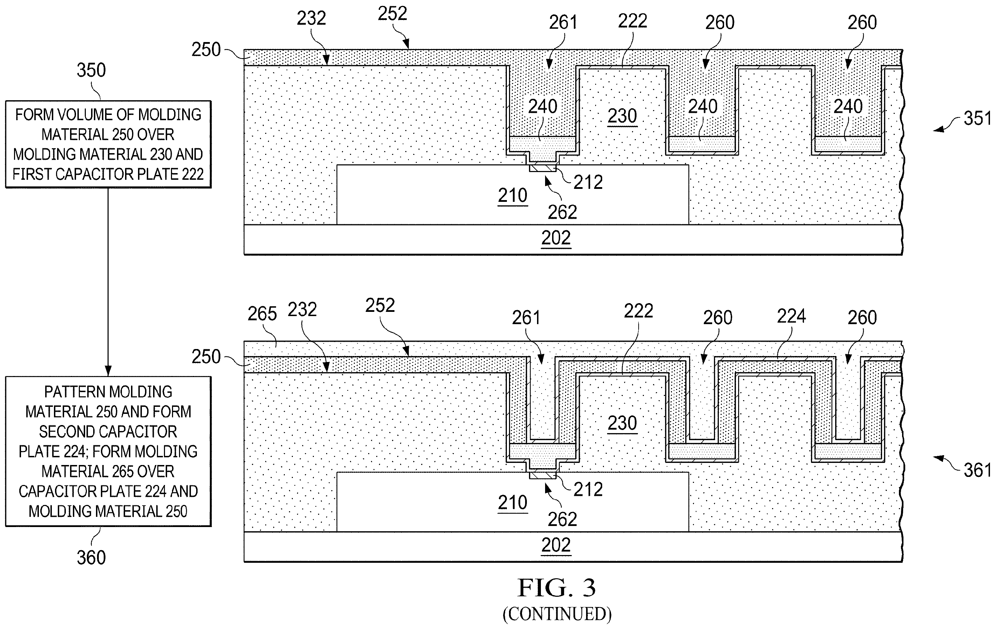

Accordingly, device packages and methods according to embodiments herein enable the integration of capacitors with other devices in molded device packages in a space-saving and cost-effective manner. Along these lines, FIG. 1A and FIG. 1B depict simplified example packages that include one or more electronic devices (represented as semiconductor die) and a capacitor structure that is integrated within the molding material used to form the package. As shown in FIG. 1A, the device package 100A includes two die 110 on a substrate (a carrier 102) that are coupled to an integrated capacitor 120. The die 110 are encapsulated or otherwise surrounded by a volume of molding material 130. A second volume of molding material 150 is disposed over the first volume of molding material 130. As will be explained further below in connection with FIG. 3, portions of the molding material 150 also extend into openings in the molding material 130. An additional molding material 165 (or other suitable material) is disposed over the capacitor 120 and the molding material 150 for protection.

The capacitor 120 includes a first capacitor plate 122 and a second capacitor plate 124. The capacitor plates 122, 124 can be formed from any suitably electrically-conductive material including, but not limiting to, metals, metal-loaded polymeric materials, conductive polymer materials, and combinations thereof. The capacitor plates 122, 124 are coupled to respective die 110 via electrical interconnects 125. The first capacitor plate 122 is disposed on the upper surface 132 of the molding material 130 and the second capacitor plate 124 is formed on the upper surface 152 of the molding material 150.

**As** an additional example, as shown in FIG. 1B, the device package 100B includes a single die 110. In this example, the capacitor plate 122 is electrically connected to the die 110 via an interconnect 125 and the capacitor plate 124 is connected to a contact 104 or another feature on the carrier 102. For instance, the contact 104 can be electrically connected to a ground plane or other reference voltage node, a voltage source, or an electrical contact that passes through the package to allow connection to an external device, as nonlimiting examples.

In one or more embodiments, as shown in the example of FIG. 1A, an integrated capacitor such as the capacitor 120 can be used to capacitively couple two or more electronic components such as the two die 110 to each other. In one or more embodiments, such an integrated capacitor is configured to allow capacitive communication between two devices such as two die 110. This can be particular useful in applications where galvanic isolation is required between devices that are operated in different voltages (e.g., a device that includes a switch exposed to voltages greater than 100V and a low-voltage device that would be damaged if exposed to voltages greater than 10V, as one nonlimiting example).

The carrier 102 can be any suitable substrate including, as a nonlimiting examples, a polymer-based circuit board, a ceramic circuit board, a lead frame, and so on. In one or more embodiments, a substrate such as the carrier 102 forms a permanent part of a device package, while in one or more other embodiments, the substrate can be removed after the packaging process is completed. However, it will be appreciated that examples described herein describe packages in which the carrier 102 or a similar carrier remains part of the final molded package for ease of understanding.

The molding materials 130, 150, and 165 can be any suitable materials. One or more of the molding materials 130, 150, 165 can be the same as one or both of the other molding materials. Nonlimiting examples of materials suitable for use as the molding material 130, 150, or 165 including various epoxy resin systems. In one or more embodiments, the molding material 150 can be chosen, at least in part, to achieve desired performance characteristics of the capacitor 120. For example, since the capacitance of the capacitor 120 will be determined primarily by the shape of the capacitor plates 122, 124, the gap between then, and the dielectric constant of the molding material 150, it can be desirable in some applications for the material between the capacitor plates 122, 124 (i.e., the molding material 150) to have a high dielectric constant in order to increase the capacitance per unit area of the capacitor 120. For example, in one or more embodiments, the molding material has a relative dielectric constant of greater than 3.5, greater than 4.0, greater than 5.0, or the any suitable value, where the vacuum dielectric constant is equal to 1.0. However, it will be understood that conventional molding materials are also suitable for use and that suitable capacitance values can be achieved by choosing the dimensions and geometry of capacitor plates such as the capacitor plates 122, 124 without requiring any particular dielectric constant for the molding material or any other materials.

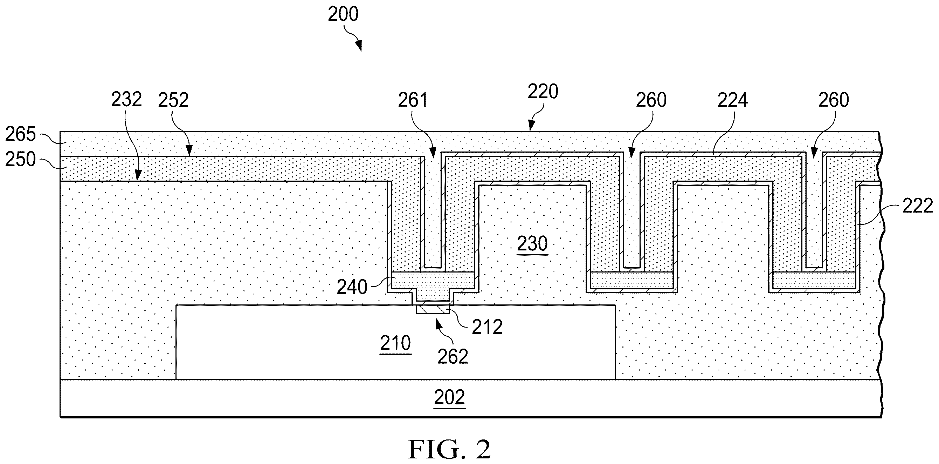

FIG. 2 shows a simplified example package in which the molding materials are patterned to allow formation of an integrated capacitor with plates that are interdigitated inside the package, allowing for higher capacitance values over a planar arrangement of the plates. Similarly to the packages 100A, 100B, the package 200 includes one or more electronic devices (represented by a die 210, e.g., a die 110) on a carrier 202 (e.g., a carrier 102) that is encapsulated within or otherwise surrounded by a first volume of molding material 230 (e.g., molding material 130), with a second volume of molding material 250 (e.g., molding material 150) disposed over the molding material 230. The upper surface 232 of the molding material 230 has an undulating or "serpentine" height profile above the carrier 202 or any other suitable reference point (e.g., the carrier 202 which can define a bottom surface of the device package or another suitable structure or feature). The capacitor plate 222 conforms to the upper surface 232 and thus also has an undulating or serpentine height profile above the carrier 202 or other suitable reference point.

The profile of the upper surface 232 of the molding material 230 defines trenches 260 in the molding material 230. The bottom of each trench 260 is coated with electrically conductive material forming the capacitor plate 222. An electrically insulated spacer 240 at the bottom of each trench 260 prevents contact between the capacitor plate 222 and the capacitor plate 224. In one or more embodiments, the spacer 240 is formed by the molding material 250. The molding material covers the capacitor plate 222 within and above each trench 260. Electrically conductive material forming the capacitor plate 224 conforms to the upper surface 252 of the molding material 250, resulting in an undulating or serpentine height profile of both capacitor plates 222, 224 and an interdigitated arrangement of the capacitor plate 222 with the capacitor plate 224. It will be appreciated that effective area of the capacitor 220 can be controlled by adjusting the dimensions and spacing of the trenches 260. The capacitance of the capacitor 220 will also depend upon the thicknesses and dielectric constants of the molding material 250 and of the spacers 240. The portions of the trenches left open after formation of the capacitor plate 224 can be filled with molding material 265 (e.g., molding material 165) or another suitable material.

Only a portion of the package 200 is shown for clarity and it should be understood that device packages and processes described herein are non-limiting examples which have been simplified for clarity. For instance, the package 200 can include any suitable number and arrangement of devices such as the die 210, electrical contacts, and other features. Similarly, although the capacitor 120 is shown connected to either two die 110 in FIG. 1A or one die 110 in FIG. 1B, an integrated capacitor according to one or more embodiments can contact any suitable number of devices, contact pads or other structures with either plate of the capacitor at any suitable locations. It will also be understood that a capacitor according to one or more embodiments is not intended to be limited to two plates. For instance, the process 300 below can be extended to form a capacitor with three or more interdigitated plates, rather than the two plates depicted. Similarly, capacitors according to one or more embodiments are not intended to be limited to coupling a single device or die to only one other device, die, or other structure and can also couple three or more die or devices in any suitable arrangement, or couple one device or die to any other suitable number of other devices, die, or other structures such as contact pads or the like.

FIG. 3 is a flow diagram illustrating steps in an example process suitable for fabricating a molded device package with one or more integrated capacitors according to one or more embodiments. The process 300 includes steps 310, 320, 330, 340, 350, and 360. These steps are described below with reference to corresponding cross-sectional illustrations (cross-sections 311, 321, 331, 341, 351, and 361) of the package 200 being fabricated using the process 300. It will be understood that the process 300 can be modified as described further below to fabricate related packages such as the package 100A or the package 100B.

At step 310, as illustrated by the cross-section 311, the carrier 202 is received with the die 210 bonded to it.

**At** step 320, as illustrated by the cross-section 321, a volume of the molding material 230 is formed over the die 210 and the carrier 202.

At step 330, as illustrated by the cross-section 331, the molding material 230 is patterned to form the trenches 260 and electrically-conductive material is deposited or otherwise formed on the upper surface 232 of the molding material 230 to form the capacitor plate 222 of the capacitor 220. As shown, one of the trenches 260 (a contact trench 261) includes a second, deeper portion 262 that extends to the top of the die 210. The portion of the capacitor plate 222 that is formed in the deeper portion 262 of the contact trench 261 makes electrical contact to a contact pad 212 on the die 210 similarly to the interconnects 125 in FIG. 1A that make electrical contact with the contact pads 112 and the interconnect 125 in FIG. 1B that contacts the contact 104 on the carrier 102. It will be understood that a device package according to embodiments herein can have any suitable number of trenches such as the contact trench 261 and any suitable number of trenches such as the other trenches 260. It will also be understood that there is no requirement for a contact trench such as the contact trench 261 and that such trenches can be omitted in one or more embodiments.

The trenches 260 can be formed by any suitable process, including, but not limited to a photolithographic process in which a masking material (e.g., a photoresist) is patterned on the upper surface 232 to act as an etch mask for a process that removes the molding material 230 that is not protected by the masking material. As another example, all or part of the trenches 260 can be formed by direct laser drilling or mechanical drilling.

The capacitor plate 222 can be formed by selective depositing metal or another suitable electrically conductive material using any suitable process including, but not limited to sputtering, thermal evaporation, electroplating, or a combinations of such processes. In one or more embodiments, the molding material is a polymer material suitable for use in a laser direct structuring ("LDS") process that contains one or more metal-containing additives. Areas where metallization is desired are patterned with a laser, exposing metal particles on the surface of the molding material which can then be used as nucleation sites in an electroplating process that forms the capacitor plate 222.

At step 340, as illustrated by the cross-section 341, a spacer 240 is formed in each trench 260, covering the portions of the capacitor plate 222 at the bottom of each trench 260. In one or more embodiments, a spacer such as the spacer 240 is absent (i.e., step 340 is not performed) or the spacer 240 is part of the molding material 250 formed at step 350.

**At** step 350, as illustrated by the cross-section 351, a volume of the molding material 250 is formed over the molding material 230, filling the trenches 260 (including the contact trench 261).

**At** step 360, as illustrated by the cross-section 361, a portion of the molding material 250 is removed from the center of each trench 260 (forming a second inner trench within each trench 260), and the capacitor plate 224 is formed over the molding material 250. After formation of the capacitor plate 224, the trenches in the volume of second molding material formed within each of the trenches 260 can be refilled with additional molding material 265. The molding material 265 can also cover the upper surface 252 of the molding material 250 surrounding the trenches 260 and the portions of the capacitor plate 224 outside the trenches. The molding material 265 can be any suitable material and can be the same material as the molding material 230 or the molding material 250.

It will be appreciated that the packages 100A, 100B and similar packages can be formed using a process that is similar to the process 300. For example, if formation of the trenches 260 at step 330 is skipped (with the exception of one trench to make contact with the die 210), and formation of the spacers 240 at step 340 is skipped, the capacitor plate 222 will resemble the capacitor plate 122 in FIG. 1A and FIG. 1B. With related modifications to the process 300 at step 350, the capacitor plate 224 will resemble the capacitor plate 124 in FIG. 1A and FIG. 1B.

### EXAMPLES

Features of embodiments may be understood by way of one or more of the following examples:
Example 1: A device package or method of making a device package that includes a first electronic device surrounded by a first volume of molding material; a second volume of molding material formed over the first volume of molding material; and a capacitor electrically coupled to the first electronic device. The capacitor includes a first capacitor plate formed on a top surface of the first volume of molding material above the first electronic device; and a second capacitor plate formed on a top surface on the second volume of molding material that is separated from the first capacitor plate by the second volume of molding material.
Example 2: The device package or method of Example 1, in which a first electrically conductive interconnect passes through the first volume of molding material and electrically couples the first capacitor plate to an electrical contact on the first electronic device.
Example 3: The device package or method of Example 1 or Example 2, that also includes a contact trench formed in the first volume of molding material above the first electronic device.
Example 4: The device package or method of Example 3 where the first electronic device is a semiconductor die having a metallic contact pad exposed at the bottom of the contact trench.
Example 5: The device package or method of any of Example 3 or Example 4 where the first capacitor plate conforms to walls of the contact trench and electrically contacts the metallic contact pad of the semiconductor die at the bottom of the contact trench.
Example 6: The device package or method of any one of Examples 1-3, that further includes a second electronic device surrounded by the first volume of molding material;
Example 7: The device package or method of any of Examples 1-6 including a second electronic device that is capacitively coupled to the first electronic device by the capacitor.
Example 8: The device package or method of any one of Examples 1-7, that further includes a second electrically conductive interconnect that passes through the first volume of molding material and electrically couples the second capacitor plate to an electrical contact on the second electronic device.
Example 9: The device package or method of any one of Examples 1-8, further includes a second electrically conductive interconnect that passes through the first volume of molding material and electrically couples the second capacitor plate to a reference voltage node.
Example 10: The device package or method of any one of Examples 1-6, where the first capacitor plate has an undulating height above a bottom surface of the device package along a length of the capacitor and the second capacitor plate has an undulating height above the bottom surface of the device package along the length of the capacitor. In this Example, the first capacitor plate and the second capacitor plate are arranged in an interdigitated fashion.
Example 11: The device package or method of any one of Examples 1-10, where a top surface of the first volume of molding material has an undulating height; where the first capacitor plate conforms to the top surface of the first volume of molding material; where the second volume of molding material has an undulating height that follows the undulating height of the first volume of molding material; and where the second capacitor plate conforms to a top surface of the second volume of molding material.
Example 12: The device package or method of any one of Examples 1-11, that further includes first trenches formed in the first volume of molding material.
Example 13: The device package or method of any one of Examples 1-12, that further includes an electrically-insulating spacer formed above the first capacitor plate, at a bottom of each of the first trenches.
Example 14: The device package or method of any one of Example 13, where the second volume of molding material overlies a spacer in each trench of set of first trenches.
Example 15: The device package or method of any one of Examples 1-14, that further includes second trenches formed in the second volume of molding material.
Example 16: The device package or method of Example 15 where a portion of the spacer in each of the first trenches is exposed at a bottom of each of the second trenches; and where the second capacitor plate overlies the portion of the spacer exposed at the bottom of each of second trenches.

The preceding detailed description and Figures referenced therein are examples. They are illustrative in nature and are not intended to limit the embodiments of the Disclosure and uses of such embodiments. It should therefore be understood that embodiments of this Disclosure are not limited in their application to the details of construction and the arrangement of components set forth in the preceding Description or illustrated in the accompanying Figures.

The connecting lines shown in the various figures contained herein are intended to represent exemplary functional relationships and/or physical couplings between the various elements. It should be noted that many alternative or additional functional relationships or physical connections may be present in one or more embodiments of this Disclosure.

**As** used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description. It is to be understood that other phraseology and terminology used herein is for the purpose of description and should not be regarded as limiting.

The terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. Herein, "A, B, and/or C" is defined as "A or B or C" or any combination of A, B, or C.

As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations of the figures may depict exemplary arrangements of elements, additional intervening elements, devices, features, or components may be present in one or more embodiments of the depicted subject matter.

The terms "first," "second" and other such numerical terms referring to structures do not imply a sequence or order unless clearly indicated by the context. Thus, the terms "first," "second," "third," "fourth" and the like in the description and the claims, if any, may be used for distinguishing between similar elements and not necessarily for describing a particular sequential or chronological order. It is to be understood that numerical terms used herein are interchangeable under appropriate circumstances such that the embodiments of the invention described herein are, for example, capable of operation in sequences other than those illustrated or otherwise described herein.

It will be appreciated that the steps of various processes described herein are non-limiting examples of suitable processes according to embodiments and are for the purposes of illustration. Systems and devices according to embodiments herein may use any suitable processes including those that omit steps described above, perform those steps and similar steps in different orders, and the like. It will also be appreciated that well-known process steps may be omitted for clarity.

As used herein the terms "approximate," "approximately," "substantial" and "substantially" mean sufficient to accomplish the stated purpose in a practical manner and that minor imperfections, if any, are not significant for the stated purpose. Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described.

While at least one exemplary embodiment has been presented in the foregoing detailed description, it should be appreciated that a vast number of variations exist. It should also be appreciated that example embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A device package, comprising:
a first electronic device surrounded by a first volume of molding material;
a second volume of molding material formed over the first volume of molding material; and
a capacitor electrically coupled to the first electronic device, the capacitor
comprising:
a first capacitor plate formed on a top surface of the first volume of molding material above the first electronic device; and
a second capacitor plate formed on a top surface on the second volume of molding material that is separated from the first capacitor plate by the second volume of molding material.

2. The device package of Claim 1, further comprising a first electrically conductive interconnect that passes through the first volume of molding material and electrically couples the first capacitor plate to an electrical contact on the first electronic device.

3. The device package of Claim 1 or Claim 2, further comprising a contact trench formed **in** the first volume of molding material above the first electronic device;
wherein the first electronic device is a semiconductor die having a metallic contact pad exposed at the bottom of the contact trench; and
wherein the first capacitor plate conforms to walls of the contact trench and electrically contacts the metallic contact pad of the semiconductor die at the bottom of the contact trench.

4. The device package of any preceding claim, further comprising a second electronic device surrounded by the first volume of molding material;
wherein the second electronic device is capacitively coupled to the first electronic device by the capacitor.

5. The device package of Claim 4, further comprising a second electrically conductive interconnect that passes through the first volume of molding material and electrically couples the second capacitor plate to an electrical contact on the second electronic device.

6. The device package of Claim 4, further comprising a second electrically conductive interconnect that passes through the first volume of molding material and electrically couples the second capacitor plate to a reference voltage node.

7. The device package of any of Claim 4 to Claim 6,
wherein the first capacitor plate has an undulating height above a bottom surface of the device package along a length of the capacitor;
wherein the second capacitor plate has an undulating height above the bottom surface of the device package along the length of the capacitor; and
wherein the first capacitor plate and the second capacitor plate are arranged in an interdigitated fashion.

8. The device package of any of Claim 4 to Claim 6,
wherein a top surface of the first volume of molding material has an undulating height;
wherein the first capacitor plate conforms to the top surface of the first volume of molding material;
wherein the second volume of molding material has an undulating height that follows the undulating height of the first volume of molding material; and
wherein the second capacitor plate conforms to a top surface of the second
volume of molding material.

9. The device package of any preceding claim, further comprising first trenches formed in the first volume of molding material and an electrically-insulating spacer formed above the first capacitor plate, at a bottom of each of the first trenches;
wherein the second volume of molding material overlies the spacer in each of the first trenches.

10. The device package of Claim 9, further comprising second trenches formed in the second volume of molding material;
wherein a portion of the spacer in each of the first trenches is exposed at a bottom of each of the second trenches; and
wherein the second capacitor plate overlies the portion of the spacer exposed at the bottom of each of second trenches.

11. A method of forming a device package, the method comprising:
surrounding a first electronic device with a first volume of molding material;
forming a capacitor that is electrically coupled to the first electronic device by:
forming a first capacitor plate formed on a surface of the first volume of molding material;
forming a second volume of molding material formed over the first volume of molding material; and
forming a second capacitor plate on a surface on the second volume of molding material that is separated from the first capacitor plate by the second volume of molding material.

12. The method of Claim 11, further comprising forming a first electrically conductive interconnect that passes through the first volume of molding material and electrically couples the first capacitor plate to an electrical contact on the first electronic device.

13. The method of Claim 12, further comprising forming a contact trench in the first volume of molding material above the first electronic device;
wherein the first electronic device is a semiconductor die having a metallic contact pad exposed at the bottom of the contact trench; and
wherein the first capacitor plate conforms to walls of the contact trench and electrically contacts the metallic contact pad of the semiconductor die at the bottom of the contact trench.

14. The method of Claim 12 or Claim 13, further comprising surrounding a second electronic device with the first volume of molding material;
wherein the second electronic device is capacitively coupled to the first electronic device by the capacitor.

15. The method of Claim 14, further comprising forming a second electrically conductive interconnect that passes through the first volume of molding material and electrically couples the second capacitor plate to an electrical contact on the second electronic device.
